Europäisches Patentamt

European Patent Office

Office européen des brevets

(11) Publication number: **0 050 033**
**B1**

# (12) EUROPEAN PATENT SPECIFICATION

(45) Date of publication of patent specification: **13.02.85**

(21) Application number: **81304750.3**

(22) Date of filing: **12.10.81**

(51) Int. Cl.⁴: **H 03 F 1/52, H 03 K 17/08**

(54) A line driver circuit including a protective circuit against excess current.

(30) Priority: **13.10.80 JP 142603/80**

(43) Date of publication of application:
**21.04.82 Bulletin 82/16**

(45) Publication of the grant of the patent:
**13.02.85 Bulletin 85/07**

(84) Designated Contracting States:
**DE FR GB NL**

(56) References cited:
**EP-A-0 032 985**
**DE-B-1 110 231**
**DE-B-2 854 313**
**US-A-3 553 598**
**US-A-3 599 042**
**US-A-3 979 643**
**US-A-4 023 111**
**US-A-4 084 070**

(73) Proprietor: **FUJITSU LIMITED**
**1015, Kamikodanaka Nakahara-ku**
**Kawasaki-shi Kanagawa 211 (JP)**

(72) Inventor: **Sumi, Hideji**
**488-2-1-301 Sugeta-cho Kanagawa-ku**
**Yokohama-shi Kanagawa 221 (JP)**
Inventor: **Kokado, Masayuki**
**5-16-1-405 Masugata Tama-ku**
**Kawasaki-shi Kanagawa 214 (JP)**

(74) Representative: **Rackham, Stephen Neil et al**
**GILL JENNINGS & EVERY 53-64 Chancery Lane**
**London WC2A 1HN (GB)**

Courier Press, Leamington Spa, England.

## Description

The present invention relates to a line driver circuit having a protective circuit against excess current, for protecting a transistor at the output stage from being thermally destroyed by a short circuit in the output circuit.

The line driver circuit is used to transmit signals from, for example, a terminal unit, through a transmission line, to a computer a long distance away, or vice versa. If a short occurs in the load of the line driver circuit, for example, in the transmission line, excess currents are conducted through transistors which are provided in the output stage, resulting in the thermal destruction of the transistors. The shorts may occur by, for example, a faulty connection of the transmission line to the line driver circuit during an inspection of the circuit. Examples of such circuits are shown in US—A—3979643 and US—A—4023111.

A conventional line driver circuit having a protective circuit against excess currents is also known and comprises an input end for receiving an input signal; an output end for outputting a line driving signal; a power supply line for supplying an operating voltage to the line driver circuit; an emitter follower circuit constituting an output stage of the line driver circuit, the emitter follower circuit having an emitter-follower transistor which is turned on or off in response to the input signal, the emitter-follower transistor having a base collector, and an emitter connected to the output end; a detecting means connected between the power supply line and the collector of the emitter follower transistor, for generating a voltage in accordance with a current flowing through the emitter follower transistor to the output end; and, a protective transistor having a base, collector, and an emitter connected to the output end, the base being biased to a potential allowing the protective transistor to be non-conductive during a normal operation of the line drive circuit.

However, there are disadvantages in the conventional line driver circuit. The first disadvantage is that the maximum short-circuit current flowing through the output-stage transistor is too large to protect the output-stage transistor. The second disadvantage is that the maximum short-circuit current flowing through the output-stage transistor cannot be precisely determined, because the maximum short-circuit current is determined by resistances and the characteristics of the transistors, both of which vary as a result of their manufacturing processes.

According to this invention, such a line driver circuit also comprises a pull-up transistor having a collector and an emitter connected between the base of the protective transistor and the power supply line, and also having a base controlled by the output voltage of the detecting means, the pull-up transistor being turned on when the output voltage of the detecting means exceeds a predetermined value to raise the base potential of the protective transistor to turn it on, whereby the input current flowing from the input end to the emitter follower circuit is decreased by the current being passed through the collector of the protective transistor.

Two examples of the line driver circuits according to this invention will now be described and contrasted with a conventional line driver circuit with reference to the accompanying drawings; in which:—

Figure 1 is a circuit diagram of a conventional line driver circuit including a protective circuit;

Figure 2 is a graph illustrating the protective function of the circuit shown in Figure 1;

Figure 3 is a circuit diagram of a line driver circuit including a protective circuit in accordance with an embodiment of the present invention;

Figure 4 is a graph illustrating the protective function of the circuit shown in Figure 3; and,

Figure 5 is a circuit diagram of a line driver circuit of another embodiment in accordance with the present invention.

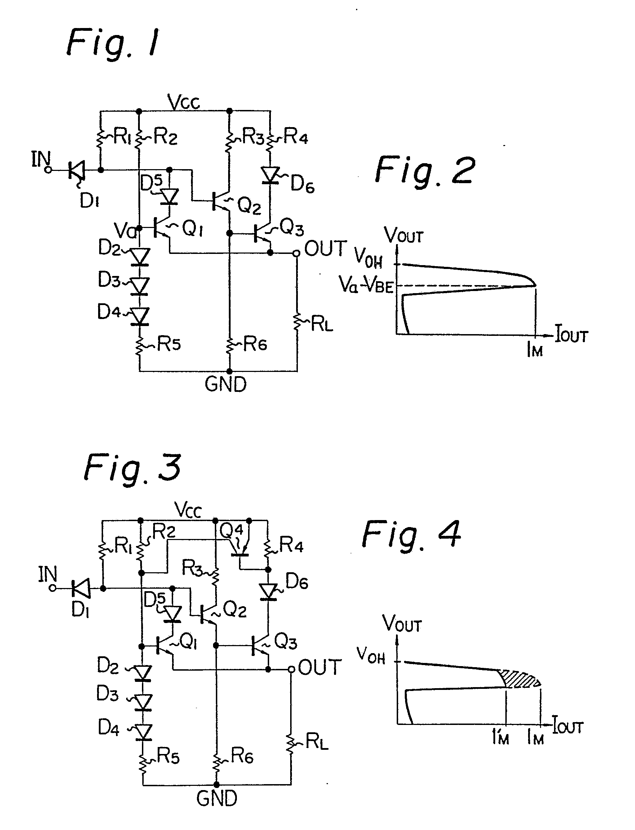

Before explaining the preferred embodiments of the present invention, a conventional line driver circuit having a protective circuit against excess currents will first be described with reference to Figs. 1 and 2. Referring to Fig. 1, $Q_1$ represents a protective transistor; and, $Q_2$ and $Q_3$ constitute an emitter-follower circuit at the output stage of the line driver circuit. The base of the transistor $Q_1$ is connected through a pull-up resistor $R_2$ to a power supply line Vcc. The potential at the base of the transistor $Q_1$ is clamped to a predetermined value Va by diodes $D_2$, $D_3$ and $D_4$ and a bias resistor $R_5$ connected in series between the base of the transistor $Q_1$ and the ground. The emitter of the transistor $Q_1$ is connected to an output terminal OUT. The collector of the transistor $Q_1$ is connected through a diode $D_5$ to the base of the transistor $Q_2$, the cathode of the diode $D_5$ being connected to the collector of the transistor $Q_1$. The diode $D_5$ prevents a reverse current from being conducted from the base to the collector when the transistor $Q_1$ goes into saturation. The base of the transistor $Q_2$ is connected through a diode $D_1$ to an input terminal IN, the cathode of the diode $D_1$ being connected to the input terminal IN. The collector of the transistor $Q_2$ is connected through a pull-up resistor $R_3$ to the power supply line Vcc. The emitter of the transistor $Q_2$ is connected through a bias resistor $R_6$ to the ground. The base of the transistor $Q_3$ is connected to the emitter of the transistor $Q_2$. The collector of the transistor $Q_3$ is connected through a diode $D_6$ and a pull-up resistor $R_4$ to the power supply line Vcc. The emitter of the transistor $Q_3$ is connected to the output terminal OUT. A load resistor $R_L$ is connected between the output terminal OUT and the ground. The diode $D_6$ also prevents a current from being conducted from the base to the collector when the transistor $Q_3$ goes into saturation.

In normal operation, when the potential at the input terminal IN is a high level (hereinafter referred to as an H level) to cut off the diode $D_1$, a current is supplied from the power supply line Vcc through the resistor $R_1$ to the base of the transistor $Q_2$ to turn it on so that the emitter current of the transistor $Q_2$ is supplied to the base of the transistor $Q_3$ to turn it on. Therefore, the potential at the output terminal OUT is the H level. In contrast, when the potential at the input terminal IN is a low level (hereinafter referred to as an L level), the diode $D_1$ is turned on so that a current flows from the power supply line Vcc through the resistor $R_1$, the diode $D_1$ to the input terminal IN. Therefore, the transistor $Q_2$ receives no base current. As a result, the transistors $Q_2$ and $Q_3$ are turned off so that the potential at the output terminal OUT is the L level.

In the circuit of Fig. 1, if the protective transistor $Q_1$ is not provided, and when the load resistor $R_L$ is short circuited so that its resistance is decreased, the collector current flowing through the transistor $Q_3$ is increased. When the collector current is excessive, the transistor $Q_3$ is thermally destroyed. The transistor $Q_1$ is provided for preventing the thermal destruction of the output-stage transistor $Q_3$. The potential at the base of the transistor $Q_1$ is clamped to the predetermined value Va as mentioned before. The value Va is so determined that Va is smaller than the potential at the output terminal in a normal state plus the voltage $V_{BE}$ between the base and the emitter of the transistor $Q_1$ to turn it on. Therefore, in a normal state, or when there is no short circuit in the load resistor $R_L$, the transistor $Q_1$ is in a cut-off state. However, when the potential at the output terminal is lowered due to, for example, a short circuit in the load resistor $R_L$, to a level lower than the difference between the values Va and $V_{BE}$, the protective transistor $Q_1$ turns on so that a current is conducted from the power supply line Vcc through the resistor $R_1$, the diode $D_5$, the transistor $Q_1$ to the output terminal OUT. Therefore, because a part of the base current of the transistor $Q_2$ is bypassed through the protective transistor $Q_1$, the base current of the transistor $Q_3$ is decreased. As a result, the collector current of the transistor $Q_3$ is limited so that the transistor $Q_3$ is protected from being thermally destroyed.

The limitation of the current flowing through the output-stage transistor $Q_3$ will be described in more detail as follows. That is, when the output current is increased due to, for example, a short in the load resistor $R_L$, the collector current of the transistor $Q_3$ is also increased so that the voltage drop across the resistor $R_4$ is increased. Accordingly, the potential at the collector of the transistor $Q_3$ is lowered, resulting in a satura-

tion of the transistor $Q_3$. When the transistor $Q_3$ is saturated, a current flows not only from the base to the emitter but also from the base to the collector so that its base current is increased. Accordingly, the emitter current of the transistor $Q_2$ is increased so that its collector current is increased, resulting in an increase in the voltage drop across the resistor $R_3$. As a result, because the potential at the collector of the transistor $Q_2$ is lowered, the transistor $Q_2$ is saturated. Then, the base current of the transistor $Q_2$ is increased so that the voltage drop across the resistor $R_1$ is increased. Therefore, the potential at the base of the transistor $Q_2$ is lowered, and accordingly, the potential at the output terminal OUT is lowered. When the potential at the output terminal is lowered, the transistor $Q_1$ turns on and the transistors $Q_2$ and $Q_3$ are turned off as mentioned before, resulting in the limitation of the collector current of the transistor $Q_3$.

Fig. 2 is a graph illustrating the relationship between the output current and the output voltage of the circuit of Fig. 1. Referring to Figs. 1 and 2, let it be assumed that the potential at the output terminal OUT is the H level, i.e., $V_{OH}$. When the output potential is lowered below the value $V_{OH}$ due to, for example, a short in the load resistor $R_L$, the output current $I_{OUT}$ is rapidly increased until the output potential reaches the value Va—$V_{BE}$. When the output potential decreases to the value Va—$V_{BE}$, the protective transistor $Q_1$ begins to turn on so that the output current is rapidly decreased from the maximum output $I_M$ to a minimum current. After this, even if the output potential $V_{OUT}$ is further lowered, the output current $I_{OUT}$ is not increased greatly.

The disadvantages of the conventional line driver circuit of Fig. 1 will be described in the following.

The first disadvantage is that, because the maximum output current $I_M$ is determined by the lowered output potential Va—$V_{BE}$, and because the value Va must be smaller than the value $V_{OH}$ plus the value $V_{BE}$, the maximum output current $I_M$ is too large to protect the transistor $Q_3$. If the value Va is designed to have a value greater than $V_{OH}+V_{BE}$, the protective transistor $Q_1$ is easily turned on in normal state, i.e., when the output potential reaches $V_{OH}$, and accordingly, the transistor $Q_1$ does not act as a protective transistor. Further, considering the noise margin, the value Va, must be sufficiently lower than $V_{OH}+V_{BE}$, because if a noise is applied to the input terminal IN, the output potential may be lowered below the value $V_{OH}$. In order to ensure that the transistor $Q_1$ is not turned on by such a noise, the value Va must be sufficiently low. Therefore, as will be seen from Fig. 2, the maximum output current is further increased in the conventional circuit of Fig. 1.

The second disadvantage is that the value of the maximum output current $I_M$ cannot be precisely determined. One of the reasons is that the value Va is determined by the clamping

diodes $D_2$, $D_3$ and $D_4$ and the resistor $R_5$. Because the characteristics of these diodes and the resistor have variations due to various manufacturing steps, the value Va cannot be determined to a designated value precisely. Another reason is that the characteristic of the curve in the graph of Fig. 2 is determined by the characteristics of the resistors $R_1$, $R_3$, and $R_4$ and the saturation characteristics of the transistors $Q_2$ and $Q_3$, these characteristics also having variations due to various manufacturing steps.

Preferred embodiments of the present invention will now be described with reference to Figs. 3 through 5.

Fig. 3 is a circuit diagram illustrating a line driver circuit having a protective circuit against excess currents, according to an embodiment of the present invention, in which like reference characters designate the same elements in the circuit of Fig. 1. The difference between the circuit of Fig. 3 and the circuit of Fig. 1 is that, in Fig. 3, a PNP transistor $Q_4$ is provided. The emitter of the transistor $Q_4$ is connected to the power supply line Vcc. The base of the transistor $Q_4$ is connected to the connecting point between the resistor $R_4$ and the diode $D_6$. The collector of the transistor $Q_4$ is connected to the base of the protective transistor $Q_1$. The resistor $R_4$ acts to detect excess currents. The transistor $Q_4$ acts to pull-up the base potential of the transistor $Q_1$ when an excess current is detected. More precisely, when the current flowing through the resistor $R_4$ is increased due to, for example, a short in the load resistor $R_L$, the voltage drop across the resistor $R_4$, that is, the voltage between the base and the emitter of the transistor $Q_4$, is increased so that the transitor $Q_4$ is turned on. Then, the base potential of the transistor $Q_1$ is pulled up through the transistor $Q_4$ to a value nearly equal to a power supply voltage Vcc. As a result, the transistor $Q_1$ is turned on. When the transistor $Q_1$ is turned on, the base current of the transistor $Q_2$ is decreased in the same way as in the circuit of Fig. 1, and accordingly, the collector current of the transistor $Q_3$ is decreased. Therefore, the transistor $Q_3$ is protected from being destroyed.

Fig. 4 is a graph illustrating the relationship between the output current $I_{out}$ and the output voltage $V_{OUT}$ of the circuit of Fig. 3. As illustrated in Fig. 4, the maximum output current $I_{M'}$ of the circuit of Fig. 3 is smaller than the maximum output current $I_M$ of the circuit of Fig. 1. The maximum output current $I_{M'}$ of the circuit of Fig. 3 is determined as:

$$I_{M'} = \frac{V_{BE}}{R_4},$$

where, $V_{BE}$ represents the voltage between the base and the emitter of the transistor $Q_4$ to turn it on, and $R_4$ represents the resistance of the resistor $R_4$. The larger the resistance $R_4$, the smaller the maximum output current $I_{M'}$. Therefore, the maximum output current $I_{M'}$ can be determined as small as possible by designing the resistance $R_4$ as an appropriate large resistance. Further, because the maximum output current $I_{M'}$, depends on only two parameters, i.e., the base-emitter voltage $V_{BE}$ and the resistance $R_4$, the maximum output current $I_{M'}$ can be designed more precisely than in the conventional case.

After the transistor $Q_1$ is turned on, the current flowing through the resistor $R_4$ is decreased as mentioned above so that the voltage between the base and the emitter of the transistor $Q_4$ is decreased to turn it off. Then, the base potential of the transistor $Q_1$ is lowered to the predetermined value Va. However, if the output potential at the output terminal OUT is still lowered, the protective transistor $Q_1$ is kept on because the voltage between the base and the emitter connected to the output terminal OUT is sufficiently large to turn on the transistor $Q_1$. Therefore, any excess current does not conduct through the output-stage transistor $Q_3$.

In the circuit of Fig. 3, let us assume that the protective transistor $Q_1$ is in an on state, and that the pull-up transistor $Q_4$ is in an off state. In this condition, the potential at the base of the transistor $Q_1$ is clamped to the predetermined value Va. Therefore, even when the input terminal IN receives a signal of the L level after the cause of the short is removed, the transistor $Q_1$ is still kept on. Accordingly, when the input terminal IN receives a signal of the H level, a current is conducted from the power supply line through the resistor $R_1$, the diode $D_5$, and the transistor $Q_1$ to the output terminal OUT, so that the transistor $Q_2$ receives no base current. Therefore, the transistor $Q_2$ can not be turned on, even when the H level signal is applied to the input terminal after the cause of the short is removed.

In practice, when the input terminal IN receives the L level signal after repairing the short, the potential at the base of the transistor $Q_1$ is lowered to turn it off, for resetting the line driver circuit.

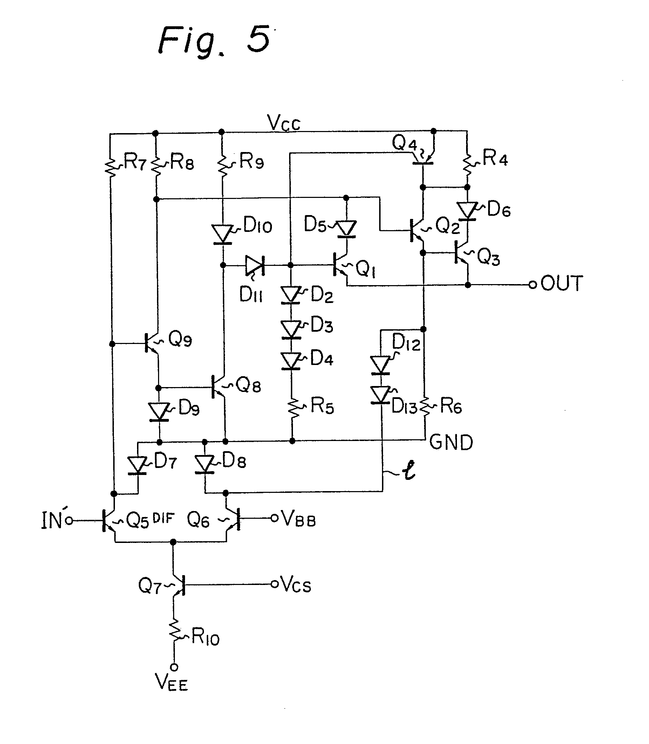

Fig. 5 is a circuit diagram illustrating a line driver circuit having a protective circuit against excess currents, a reset circuit, a discharge circuit, and a converting circuit for converting the ECL level to the TTL level, according to another embodiment of the present invention. Referring to Fig. 5, like reference characters designate the same or similar elements as in the circuit of Fig. 3. The difference between the circuit of Fig. 5 and the circuit of Fig. 3 is that, in Fig. 5, transistors $Q_5$, $Q_6$, $Q_7$, $Q_8$ and $Q_9$, diodes $D_7$ through $D_{13}$, and resistors $R_7$ through $R_{10}$ are provided. An input terminal IN' receives input signals which have two values, i.e., a high potential of zero volts (ground level) and a low potential of a negative voltage $V_{EE}$. The input terminal IN' is connected to the base of the

transistor $Q_5$. The base of the transistor $Q_6$ is connected to a reference terminal for receiving a reference voltage $V_{BB}$ which has a value between zero volts and $V_{EE}$. The collector of the transistor $Q_5$ is connected through the pull-up resistor $R_7$ to the power supply line $V_{CC}$. The emitter-coupled transistors $Q_5$ and $Q_6$ consist of a differential pair DIF. The common emitters are connected through the transistor $Q_7$ and the resistor $R_{10}$ to the negative voltage source $V_{EE}$. When the input terminal IN' receives zero volts, the transistor $Q_5$ is on and the transistor $Q_6$ is off. When the input terminal IN' receive the negative voltage $V_{EE}$, the transistor $Q_5$ is off and the transistor $Q_6$ is on. The collector of the fifth transistor $Q_5$ is also connected to the base of the transistor $Q_9$. The collector of the transistor $Q_9$ is connected through the pull-up resistor $R_8$ to the power supply line $V_{CC}$ and is also connected to the base of the transistor $Q_2$. The emitter of the transistor $Q_9$ is connected through a diode $D_9$ to the ground line GND and is also connected to the base of the resetting transistor $Q_8$. The collector of the transistor $Q_8$ is connected through the diode $D_{11}$ to the base of the transistor $Q_1$. The emitter of the transistor $Q_8$ is connected to the ground line GND. The collector of the transistor $Q_8$ is also connected through the diode $D_{10}$ and the resistor $R_9$ to the power supply line $V_{CC}$. The transistor $Q_8$ acts to reset the base potential of the transistor $Q_1$. Between the collector of the transistor $Q_5$ and the ground line GND, the diode $D_7$ is connected for preventing a reverse current when the transistor $Q_5$ is saturated. Between the base of the transistor $Q_3$ and the collector of the transistor $Q_6$, the diodes $D_{12}$ and $D_{13}$ are connected in series for discharging charges on the base of the transistor $Q_3$ when the transistor $Q_3$ is turned off. Between the ground line and the collector of the transistor $Q_6$, the diode $D_8$ is connected. The diode $D_8$ and the diodes $D_{12}$ and $D_{13}$ constitute a current switch.

The reset operation of the circuit of Fig. 5 will now be described. Let us assume again that the protective transistor $Q_1$ is in an on state, and that the pull-up transistor $Q_4$ is in an off state. In this condition, and after the short in the load resistor $R_L$ is repaired, when the input terminal IN' receives a signal of the negative voltage $V_{EE}$, then the transistor $Q_5$ is off; the transistor $Q_9$ is on; the transistor $Q_8$ is on; and therefore, the base potential of the transistor $Q_1$ is turned to the L level, so that the transistor $Q_1$ is turned off. After this, when the input terminal IN' receives a signal of zero volts, the transistor $Q_5$ is turned on and the transistor $Q_9$ is turned off so that a base current is supplied from the power supply line $V_{CC}$ through the resistor $R_8$ to the base of the transistor $Q_2$ to turn it on. Accordingly, the transistor $Q_3$ is turned on.

When the output transistor $Q_3$ is turned off, charges on the base of the transistor $Q_3$ are rapidly discharged through a discharge path I including the diodes $D_{12}$ and $D_{13}$, the transistors

$Q_6$ and $Q_7$, and the resistors $R_{10}$ to the negative voltage source $V_{EE}$.

The operations of the protective transistor $Q_1$, the pull-up transistor $Q_4$, and the excess-current detecting resistor $R_4$ are substantially the same as in the circuit of Fig. 3.

From the foregoing description, it will be apparent that, according to the present invention, in a line driver circuit having a protective circuit against excess currents, by providing a pull-up transistor for pulling up the base potential of the protective transistor, the maximum output current flowing through the output-stage transistor due to, for example, a short in the load resistor can be limited to a small amount in comparison with the conventional circuit. Further, according to the present invention, because the maximum output current depends only on the current detecting resistance and the characteristic of the pull-up transistor, the maximum output current can be determined more precisely over the conventional circuit.

## Claims

1. A line driver circuit having a protective circuit against excess current comprising:

an input end (IN) for receiving an input signal;

an output end (OUT) for outputting a line driving signal;

a power supply line ($V_{cc}$) for supplying an operating voltage to the line driver circuit;

an emitter follower circuit ($Q_2$, $Q_3$) constituting an output stage of the line driver circuit, the emitter follower circuit having an emitter-follower transistor ($Q_3$) which is turned on or off in response to the input signal, the emitter-follower transistor ($Q_3$) having a base, collector, and an emitter connected to the output end (OUT);

a detecting means ($R_4$) connected between the power supply line ($V_{cc}$) and the collector of the emitter follower transistor ($Q_3$), for generating a voltage in accordance with a current flowing through the emitter follower transistor ($Q_3$) to the output end; and,

a protective transistor $Q_1$) having a base, collector, and an emitter connected to the output end (OUT), the base being biased to a potential allowing the protective transistor to be non-conductive during a normal operation of the line driver circuit;

characterised in that the line driver circuit further comprises a pull-up transistor ($Q_4$) having a collector and an emitter connected between the base of the protective transistor ($Q_1$) and the power supply line ($V_{cc}$), and also having a base controlled by the output voltage of the detecting means ($R_4$), the pull-up transistor being turned on when the output voltage of the detecting means ($R_4$) exceeds a predetermined value to raise the base potential of the protective transistor ($Q_1$) to turn it on, whereby the input current flowing from the input end (IN) to the emitter follower circuit ($Q_2$, $Q_3$) is decreased by the current being passed through the collector of the protective transistor ($Q_1$).

2. A line driver circuit according to claim 1, in which the detecting means comprises a resistor ($R_4$).

3. A line driver circuit according to claims 1 or 2, in which the collector of the protective transistor ($Q_1$) is connected through a diode ($D_5$) to the emitter-follower circuit, the emitter-follower circuit is connected through another diode ($D_1$) to the input end (IN), and the emitter-follower circuit is connected through a further diode ($D_6$) to the detecting means ($R_4$).

4. A line driver circuit according to claims 2 or 3, in which the pull-up transistor comprises a PNP transistor ($Q_4$) having its emitter and base connected across the resistor ($R_4$).

5. A line driver circuit according to claim 4, in which the protective transistor ($Q_1$) comprises an NPN transistor having its base connected to the collector of the pull-up transistor ($Q_4$) and its emitter connected to the output terminal (OUT) of the line driver circuit.

6. A line driver circuit according to claim 5, in which the emitter-follower circuit comprises an output stage NPN transistor ($Q_3$) having its collector coupled to the base of the pull-up transistor ($Q_4$) and its emitter connected to the output terminal (OUT).

7. A line driver circuit according to any one of the preceding claims, in which diodes ($D_2$, $D_3$, $D_4$) connected between the base of the protective transistor ($Q_1$) and ground clamp the base of the protective transistor ($Q_1$) at a predetermined value ($V_a$) lower than the sum of the output potential of the normal state and $V_{BE}$, where $V_{BE}$ represents the base emitter voltage for turning on the protective transistor ($Q_1$).

8. A line driver circuit according to any one of the preceding claims, further comprising a reset circuit to turn off the protective transistor ($Q_1$).

9. A line driver circuit according to claim 8, in which the rest circuit comprises a resetting transistor ($Q_8$, Figure 5) the collector of which is connected to the base of the protective transistor ($Q_1$), the emitter of which is connected to ground and the base of which is coupled to the input terminal (IN') of the line driver circuit, the resetting transistor ($Q_8$) turning off the protective transistor ($Q_1$) upon the signal applied to the input terminal (IN') having a low state.

## Patentansprüche

1. Leitungstreiberschaltung mit einem Überstrom-Schutzschaltkreis, mit

einem Eingangsende (IN) zum Empfang eines Eingangssignals,

einem Ausgangsende (OUT) zur Ausgabe eines Leitungstreibersignals,

einer Energieversorgungsleitung ($V_{cc}$) zur Zuführung einer Betriebsspannung zu der Leitungstreiberschalttung,

einer Emitterfolgeschaltung ($Q_2$, $Q_3$), die eine Ausgangsstufe der Leitungstreiberschaltung bildet und einen Emitterfolgetransistor ($Q_3$) umfaßt, der in Abhängigkeit von dem Eingangssignal ein- oder ausgeschaltet wird und der eine Basis, einen Kollektor und einen Emitter umfaßt, der mit dem Ausgangsende (OUT) verbunden ist,

einer Detektoreinrichtung ($R_4$), die zwischen der Energieversorgungsleitung ($V_{cc}$) und dem Kollektor des Emitterfolgetransistors ($Q_3$) verbunden ist, um in Übereinstimmung mit einem durch den Emitterfolgetransistor ($Q_3$) zu dem Ausgangsende fließenden Strom eine Spannung zu erzeugen, und

einem Schutztransistor ($Q_1$), mit einer Basis, einem Kollektro und einem Emitter, der mit dem Ausgangsende verbunden ist und dessen Basis mit einem Potential vorgespannt ist, welches erlaubt, daß der Schutztransistor während eines normalen Betriebs der Leitungstreiberschaltung nichtleitend ist,

dadurch gekennzeichnet, daß die Leitungstreiberschaltung ferner einen pull-up-Transistor ($Q_4$) umfaßt, dessen Kollektor und Emitter zwischen der Basis des Schutztransistors ($Q_1$) und der Energieversorgungsleitung ($V_{cc}$) angeschlossen sind und dessen Basis von der Ausgangsspannung der Detektoreinrichtung ($R_4$) gesteuert wird, wobei der pull-up-Transistor eingeschaltet wird, wenn die Ausgangsspannung der Detektoreinrichtung ($R_4$) einen vorbestimmten Wert überschreitet, um das Basispotential des Schutztransistors ($Q_1$) anzuheben, um ihn einzuschalten, wodurch der von dem Eingangsende (IN) zu der Emitterfolgeschaltung ($Q_2$, $Q_3$) fließende Strom durch den Strom, der durch den Kollektor des Schutztransistors ($Q_1$) geführt wird, verringert wird.

2. Leitungstreiberschaltung nach Anspruch 1, bei welcher die Detektoreinrichtung einen Widerstand ($R_4$) umfaßt.

3. Leitungstreiberschaltung nach Anspruch 1 oder 2, bei welcher der Kollektor des Schutztransistors ($Q_1$) über eine Diode ($D_5$) mit der Emitterfolgeschaltung verbunden ist, die über eine andere Diode ($D_1$) mit dem Eingangende (IN) verbunden ist, und die Emitterfolgeschaltung über eine weitere Diode ($D_6$) mit der Detektoreinrichtung ($R_4$) verbunden ist.

4. Leitungstreiberschaltung nach Anspruch 2 oder 3, bei welcher der pull-up-Transistor einen PNP-Transistor ($Q_4$) umfaßt, deren Emitter und Basis parallel zum Widerstand ($R_4$) verbunden sind.

5. Leitungstreiberschaltung nach Anspruch 4, bei welcher der Schutztransistor ($Q_1$) einen NPN-Transistor umfaßt, dessen Basis mit dem Kollektor des pull-up-Transistors ($Q_4$) und dessen Emitter mit dem Ausgangsanschluß (OUT) der Leitungstreiberschaltung verbunden sind.

6. Leitungstreiberschaltung nach Anspruch 5, bei welcher die Emitterfolgeschaltung einen Ausgangsstufen-NPN-Transistor ($Q_3$) umfaßt,

dessen Kollektor mit der Basis des pull-up-Transistors (Q₄) und dessen Emitter mit dem Ausgangsanschluß (OUT) verbunden sind.

7. Leitungstreiberschaltung nach einem der vorhergehenden Ansprüche, bei welcher Dioden (D₂, D₃, D₄), die zwischen der Basis des Schutztransistors (Q₁) und und Masse geschaltet sind, die Basis des Schutztransistors (Q₁) auf einem vorbestimmten Wert (V$_a$), der niedriger als die Summe des Ausgangspotentials des normalen Zustands und V$_{BE}$ ist, klammert, wobei V$_{BE}$ die Basis-Emitter-Spannung zur Einschaltung des Schutztransistors (Q₁) ist.

8. Leitungstreiberschaltung nach einem der vorhergehenden Ansprüche, ferner mit einer Rückstellschaltung zur Abschaltung des Schutztransistors (Q₁).

9. Leitungstreiberschaltung nach Anspruch 8, bei welcher die Rückstellschaltung einen Rückstelltransistor (Q₈, Fig. 5) umfaßt, dessen Kollektor mit der Basis des Schutztransistors (Q₁) verbunden ist, dessen Emitter mit Masse verbunden ist und dessen Basis mit dem Eingangschluß (IN) der Leitungstreiberschaltung verbunden ist, und der Rückstelltransistor (Q₈) den Schutztransistor (Q₁) auf das Signal hin, welches zu dem Eingangsanschluß geführt wird, einen niedrigen Zustand hat.

## Revendications

1. Circuit de pilotage de ligne possédant un circuit de protection contre les courants excessifs, comprenant:

— une extrémité d'entrée (IN) servant à recevoir un signal d'entrée;
— une extrémité de sortie (OUT) servant à délivrer un signal de pilotage de ligne;
— une ligne d'alimentation électrique (V$_{cc}$) servant à délivrer une tension de fonctionnement au circuit de pilotage de ligne;
— un circuit à émetteur suiveur (Q₂, Q₃) constituant un étage de sortie du circuit de pilotage de ligne, le circuit à émetteur suiveur possédant un transistor à émetteur suiveur (Q₃) qui est rendu conducteur ou non conducteur en fonction du signal d'entrée, le transistor à émetteur suiveur (Q₃) possédant une base, un collecteur, et un émetteur connecté à l'extrémité de sortie (OUT);
— un moyen de détection (R₄) connecté entre la ligne d'alimentation électrique (V$_{cc}$) et le collecteur du transistor à émetteur suiveur (Q₃), servant à produire une tension qui est fonction du courant passant dans le transistor à émetteur suiveur (Q₃) pour aller à l'extrémité de sortie; et
— un transistor de protection (Q₁) possédant une base, un collecteur, et un émetteur connecté à l'extrémité de sortie (OUT), la base étant polarisée sur un potentiel qui permet au transistor de protection de ne pas être conducteur pendant le fonctionnement normal du circuit de pilotage de ligne;

caractérisé en ce que le circuit de pilotage de ligne comprend en outre un transistor de tirage vers le haut (Q₄) possédant un collecteur et un émetteur connectés entre la base du transistor de protection (Q₁) et la ligne d'alimentation électrique (V$_{cc}$), et possédant également une base commandée par la tension de sortie du moyen de détection (R₄), le transistor de tirage vers le haut étant rendu conducteur lorsque la tension de sortie du moyen de détection (R₄) dépasse une valeur prédéterminée afin d'élever le potentiel de base du transistor de protection (Q₁) pour rendre ce dernier conducteur, si bien que le courant d'entrée passant de l'extrémité de l'entrée (IN) au circuit à émetteur suiveur (Q₂, Q₃) est diminué du courant passant dans le collecteur du transistor de protection (Q₁).

2. Circuit de pilotage de ligne selon la revendication 1, dans lequel le moyen de détection comprend une résistance (R₄).

3. Circuit de pilotage de ligne selon la revendication 1 ou 2, dans lequel le collecteur du transistor de protection (Q₁) est connecté via une diode (D₅) au circuit à émetteur suiveur, le circuit à émetteur suiveur est connecté via une autre diode (D₁) à l'extrémité d'entrée (IN), et le circuit à émetteur suiveur est connecté via une diode supplémentaire (D₆) au moyen de détection (R₄).

4. Circuit de pilotage de ligne selon la revendication 2 ou 3, dans lequel le transistor de tirage vers le haut comprend un transistor PNP (Q₄) dont l'émetteur et la base sont connectés aux bornes de la résistance (R₄).

5. Circuit de pilotage de ligne selon la revendication 4, dans lequel le transistor de protection (Q₁) comprend un transistor NPN dont la base est connectée au collecteur du transistor de tirage vers le haut (Q₄) et dont l'émetteur est connecté à la borne de sortie (OUT) du circuit de pilotage de ligne.

6. Circuit de pilotage de ligne selon la revendication 5, dans lequel le circuit à émetteur suiveur comprend un transistor NPN (Q₃) d'étage de sortie dont le collecteur est couplé à la base du transistor de tirage vers le haut (Q₄) et dont l'émetteur est connecté à la borne de sortie (OUT).

7. Circuit de pilotage de ligne selon l'une quelconque des revendications précédentes, dans lequel des diodes (D₂, D₃, D₄) connectées entre la base du transistor de protection (Q₁) et la terre verrouillent la base du transistor de protection (Q₁) sur une valeur prédéterminée (V$_a$) inférieure à la somme du potentiel de sortie de l'état normal et de V$_{BE}$, où V$_{BE}$ représente la tension base-émetteur permettant de rendre conducteur le transistor de protection (Q₁).

8. Circuit de pilotage de ligne selon l'une quelconque des revendications précédentes, comprenant en outre un circuit de repositionnement permettant de rendre non conducteur le transistor de protection (Q₁).

9. Circuit de pilotage de ligne selon la revendication 8, dans lequel le circuit de repositionnement comprend un transistor de repositionnement ($Q_5$, figure 5) dont le collecteur est connecté à la base du transistor de protection ($Q_1$), dont l'émetteur est connecté à la terre et dont la base est couplée à la borne d'entrée (IN') du circuit de pilotage de ligne, le transistor de repositionnement ($Q_8$) rendant non conducteur le transistor de protection ($Q_1$) dès que le signal appliqué à la borne d'entrée (IN') possède un état bas.

*Fig. 1*

*Fig. 2*

*Fig. 3*

*Fig. 4*

# Fig. 5